# FASCICULE DE BREVET EUROPEEN

(11) **EP 3 240 384 B1**
(45) Date de publication et mention de la délivrance du brevet: **07.04.2021**
(21) Numéro de dépôt: 17166715.7
(22) Date de dépôt: 14.04.2017
(51) Int. Cl.: H05K 5/00

(54) **MODULE DE PILOTAGE ÉLECTRONIQUE D'UN DISPOSITIF D'ÉCLAIRAGE ET/OU DE SIGNALISATION DE VÉHICULE, ET PROCÉDÉ DE REMPLACEMENT D'UN TEL MODULE**
ELEKTRONISCHES STEUERMODUL EINER BELEUCHTUNGS- UND/ODER SIGNALISIERUNGSVORRICHTUNG EINES FAHRZEUGS, UND VERFAHREN ZUM AUSWECHSELN EINES SOLCHEN MODULS
MODULE FOR ELECTRONIC CONTROL OF A LIGHTING AND/OR SIGNALLING DEVICE OF A VEHICLE, AND METHOD FOR REPLACING SUCH A MODULE

(30) Priorité: 25.04.2016 FR 1653637
(43) Date de publication de la demande: 01.11.2017
(73) Titulaire: Valeo Vision, 93012 Bobigny Cedex (FR)
(72) Inventeur: VINCENT, Steve, 49000 Angers (FR); MADELAINE, Mehdi, 49000 Angers (FR)

(56) Documents cités:
- EP-A1- 2 362 720
- EP-A1- 2 479 062
- US-A1- 2015 176 795

## Description

L'invention concerne les dispositifs d'éclairage et/ou de signalisation de véhicule automobile, et elle concerne tout particulièrement les modules de pilotage électronique équipant de tels dispositifs d'éclairage et/ou de signalisation, ainsi que les moyens mis en œuvre pour procéder au remplacement d'un module usagé ou défectueux.

Notamment pour piloter l'allumage et l'extinction des sources de lumière présentes dans un dispositif d'éclairage et/ou de signalisation de véhicule automobile, on implante dans le boîtier de ces dispositifs un module de pilotage électronique des sources, comprenant notamment une carte de pilotage électronique, autrement appelée « driver ». Une fois cette carte installée dans le boîtier du dispositif, on raccorde les composants électroniques que la carte supporte aux sources de lumière, notamment des diodes électroluminescentes. Le module de pilotage électronique permet alors de recueillir des informations sur les conditions extérieures par l'intermédiaire de capteurs d'état, ou encore des commandes provenant du conducteur, et de générer des instructions de pilotage des sources de lumière. Le module de pilotage électronique pourra par exemple piloter automatiquement l'allumage des sources de lumière dans le cadre du protocole DLR (« daytime running light »), qui oblige certains véhicules à présenter des éléments d'éclairage et/ou de signalisation s'allumant automatiquement dans la journée de manière notamment à améliorer la visibilité du véhicule lorsqu'il roule. Il a été précisé que le module de pilotage permet le pilotage en allumage et en extinction des sources de lumière, mais il sera compris qu'il peut en outre gérer les tensions d'alimentation des sources et l'intensité lumineuse produite par le dispositif associé.

Le module de pilotage électronique est rapporté à l'intérieur du boîtier du dispositif d'éclairage et/ou de signalisation, et il doit être fixé par une liaison réversible, afin de pouvoir démonter le module du boîtier lorsqu'il est défectueux et qu'il est nécessaire de l'échanger. On connait ainsi des modules de pilotage électronique disposés dans un logement formé dans le boîtier, et que l'on maintient en position dans ce logement par vissage. On comprend alors que pour remplacer un module défectueux, il convient de dévisser cette ou ces vis de fixation, de retirer le module défectueux de son logement pour l'extraire du boîtier, puis de replacer un module neuf dans ce même logement et enfin de revisser une à une chacune des vis de fixation. Cela nécessite des opérations de vissage et dévissage dans l'espace confiné du boîtier, compliquées à réaliser et chronophages.

Par ailleurs, si l'opération initiale de vissage, pour positionner le module dans le logement à l'origine, est sans risque car le boîtier est alors vide d'autres composants, on comprend que les différents composants présents dans le boîtier, et notamment les sources de lumière, ne sont pas retirés lorsqu'un module défectueux doit être échangé, de sorte que le dévissage puis le revissage s'effectue alors que les sources sont en position et qu'elles peuvent être détériorées en cas de chute de vis, de tournevis, etc.

De l'art antérieur, on connaît le document EP 2 479 062 A1 (VALEO VISION [FR]; PEUGEOT CITROEN AUTOMOBILES SA [FR]) 25 juillet 2012 (2012-07-25) qui décrit un procédé de remise en état d'un projecteur lumineux pour véhicule automobile. On connaît aussi le document US 2015/176795 A1 (KIKUCHI HIROYUKI [JP] ET AL) 25 juin 2015 (2015-06-25) qui décrit un projecteur lumineux pour automobile et le document EP 2 362 720 A1 (AIRBUS OPERATIONS SAS [FR]) 31 août 2011 (2011-08-31) qui décrit notamment la fixation d'une carte électronique sur un capot.

Un but de l'invention est de prévoir un module de pilotage électronique facile à mettre en œuvre, facile à monter dans un boîtier de dispositif d'éclairage et/ou de signalisation, et dont le remplacement en cas de disfonctionnement est rapide et sans risque. On cherche ainsi notamment à faciliter l'extraction des modules de pilotage électronique par rapport au boîtier dans lesquels ils sont intégrés.

A cet effet, on prévoit un module de pilotage électronique d'une source de lumière comportant au moins une carte support de composants électroniques configurée pour être reçue par un premier de ses bords dans un logement, caractérisé en ce que le module de pilotage présente au voisinage de ce premier bord une portion de connexion comportant au moins une nervure s'étendant perpendiculairement, ou sensiblement perpendiculairement, au plan défini par la carte. Par sensiblement perpendiculaire, on entend un écart de 1 ou 2° entre le plan médian de la nervure et le plan défini par la carte.

Ainsi, lorsqu'on souhaite ôter le module de pilotage, on n'a plus besoin de travailler à l'intérieur du boîtier. Il suffit de retirer le support du boîtier. Cette extraction est simple et rapide à effectuer.

Selon différentes caractéristiques de l'invention, prises seules ou en combinaison, on pourra prévoir que :
- le module de pilotage électronique est agencé de manière à être logé dans une position nominale dans un support solidaire d'une paroi d'un boîtier d'un dispositif lumineux,
- la portion de connexion est profilée ; on entend par « profilé » qu'une forme s'étend selon une direction donnée et présentant une section transversale constante le long de cette direction ;
- la nervure prolonge le premier bord ;
- la portion de connexion présente une forme en L ;
- la nervure s'étend à distance constante du premier bord ;
- la nervure profilée s'étend sur toute le long du premier bord ;
- un couvercle de protection des composants électroniques supportés par la carte est disposée contre la carte, et la nervure de la portion de connexion est formée sur le couvercle ;
- le couvercle présente une portion centrale bombée recouvrant les composants électroniques de la carte et un contour sensiblement plan plaqué contre la carte, la nervure de la portion de connexion étant réalisée sur ce contour de manière à former un dégagement entre la portion centrale et la portion de connexion.

L'invention concerne également un dispositif lumineux, comprenant au moins une source de lumière logée dans un boîtier ainsi qu'au moins un module de pilotage électronique selon l'invention. Par module de pilotage électronique, on entend notamment couvrir un dispositif de conversion d'une alimentation électrique issue d'un réseau d'alimentation électrique du véhicule en une alimentation électrique adaptée à la réalisation d'une fonction lumineuse souhaitée, et éventuellement à fournir ladite alimentation électrique adaptée à une source de lumière pour la réalisation de ladite fonction lumineuse souhaitée.

Notamment, on pourra prévoir que ce dispositif comporte l'une et/ou l'autre des caractéristiques suivantes :
- le boîtier définit une cavité de réception d'une ou plusieurs sources de lumière et des systèmes optiques associés, le boîtier étant fermé par une glace ;
- le module de pilotage électronique est reçu dans un logement solidaire d'une paroi du boitier ;
- le logement est venu de matière avec la paroi du boîtier ;
- la paroi du boîtier comporte une prédécoupe au droit du logement ;
- la prédécoupe comporte au moins une zone de la paroi du boîtier de moindre épaisseur ; par moindre épaisseur, on entend que l'épaisseur dans cette zone de la paroi est plus faible que l'épaisseur du reste de la paroi, créant ainsi localement une zone de fragilité permettant la découpe facile par un opérateur. ;
- le logement est formé dans un support comportant un capot, formé par une partie de la paroi du boîtier, et une glissière prolongeant le capot vers l'intérieur du boîtier, ladite glissière présentant une forme complémentaire de celle de la portion de connexion de la carte ;
- la glissière comporte une rainure configurée pour recevoir la nervure en saillie perpendiculaire de la portion de connexion de la carte ; notamment, la glissière pourra consister en deux parois prolongeant perpendiculairement le capot vers l'intérieur du boîtier, en regard l'une de l'autre, avec au moins une rainure ménagée sur la face interne de l'une des parois ;
- la rainure s'étend selon une direction parallèle au plan défini par le capot ;
- une vis de blocage est prévu dans le support pour bloquer en position le module à l'intérieur du support ;
- le boîtier comporte une paroi interne comprenant une tranchée de maintien du module de pilotage électronique au niveau d'un deuxième de ses bords, opposé au premier bord ;
- la tranchée s'étend parallèlement ou sensiblement parallèlement à la rainure agencée dans la glissière.

L'invention concerne en outre un procédé de remplacement d'un module de pilotage électronique agencé à l'intérieur d'un dispositif lumineux en étant raccordé électriquement à une ou plusieurs sources de lumière, le module de pilotage électronique étant logé dans une position nominale dans un support solidaire d'une paroi d'un boîtier du dispositif lumineux, avec au moins une nervure du module s'étendant dans une rainure du support sensiblement parallèlement à ladite paroi. Selon l'invention, on prévoit une étape de déconnexion électrique de la ou des sources de lumière avec le module de pilotage électronique à remplacer, une étape de découpe partielle de la paroi du boîtier autour du logement, depuis l'extérieur du boîtier, une étape d'extraction du support par rapport au dispositif, le support emportant le module par coopération de la nervure du module et de la rainure du support, une étape de positionnement d'un nouveau module de pilotage électronique équipé d'un support comprenant un capot de fermeture s'adaptant à l'ouverture, une étape de raccordement électrique et une étape de fixation du capot de fermeture du nouveau module de pilotage électronique sur la paroi du boîtier depuis l'extérieur du boîtier.

La paroi découpée lors de l'étape d'extraction peut être notamment prédécoupée, par exemple par une épaisseur moindre en certaines zones de la paroi.

La fixation du capot peut se faire notamment par l'intermédiaire de vis de serrage coopérant avec des fûts de serrage agencées sur la paroi du boîtier entourant la zone de découpe partielle de la paroi.

L'étape de positionnement par insertion du nouveau module de pilotage électronique dans l'ouverture formée par la découpe de la partie de paroi peut être réalisée jusqu'à buter avec le deuxième bord de la carte électronique contre la tranchée formée dans la paroi interne du boîtier agencée en regard de l'ouverture.

Les caractéristiques de l'invention mentionnées ci-dessus ainsi que d'autres, apparaîtrons plus clairement à la lecture ci-dessous de la description détaillée d'exemples non limitatifs, en se référant aux dessins annexés parmi lesquels :
- la figure 1 illustre un dispositif lumineux, notamment d'éclairage et/ou de signalisation de véhicule automobile, vu de dessus ;
- la figure 2 est une vue du boîtier formant partie du dispositif de la figure 1, vu de l'intérieur en perspective ;
- la figure 3 est une vue en perspective d'un module de pilotage électronique selon un mode de réalisation de l'invention ;
- la figure 4 est une vue en perspective d'un support selon un mode de réalisation, le module de pilotage de la figure 3 étant configuré pour être reçu dans le support de la figure 4 ;
- les figures 5 et 6 illustrent un ensemble formé du module de pilotage de la figure 3 et du support de la figure 4, dans une configuration assemblée, vu en perspective (figure 5) ou en coupe (figure 6) ;
- les figures 7 et 8 illustrent l'ensemble des figures 5 et 6 implanté dans un boîtier du dispositif lumineux, dans une position de fonctionnement, vue depuis l'intérieur du boîtier (figure 7) et depuis l'extérieur du boîtier (figure 8) ;
- la figure 9 illustre une étape successive d'un procédé de remplacement d'un module de pilotage électronique défectueux, lors de laquelle on retire l'ensemble des figures 5 et6 de l'intérieur du boîtier, par découpage d'une partie de la paroi illustrée sur la figure 8.

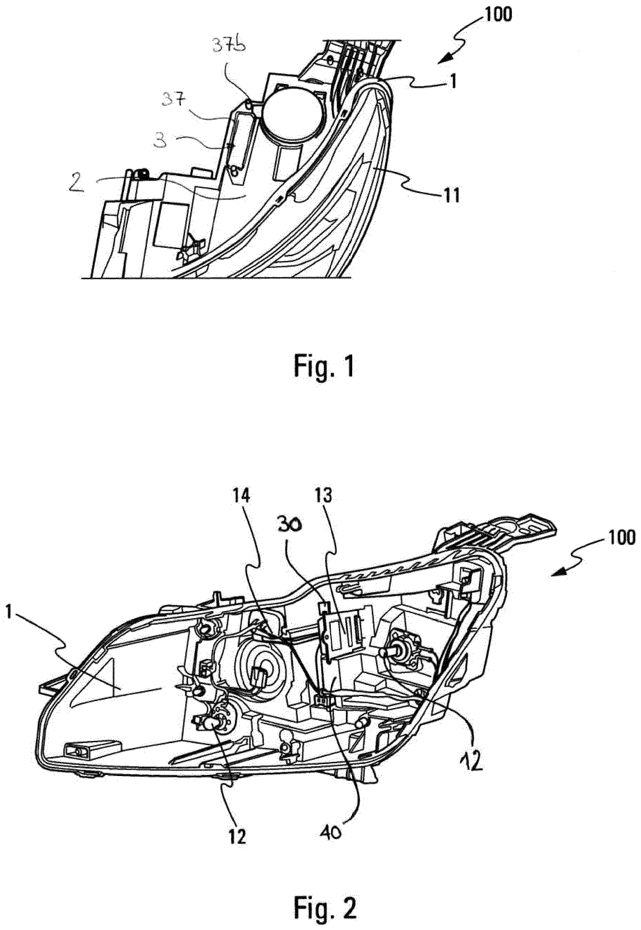

Le dispositif 100 de la figure 1 est un dispositif d'éclairage et de signalisation de véhicule, comprenant un boîtier 1, fermé par une vitre 11 pour définir une zone de réception d'un ou plusieurs modules lumineux configurés pour la réalisation d'une fonction d'éclairage et/ou de signalisation. Un module lumineux comporte au moins une source de lumière 12 et un module de pilotage électronique 13, le module 13 étant connecté à la source de lumière 12 par des liaisons 14 telles que des câbles électriques.

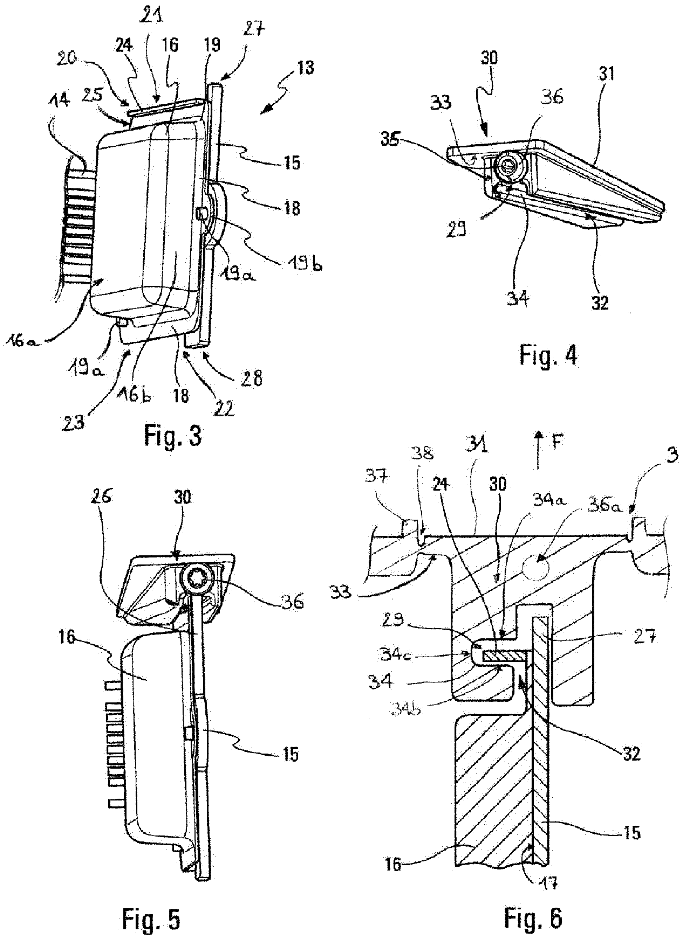

Tel que cela a pu être précisé précédemment, le module de pilotage électronique 13 détermine en fonction de données qu'il reçoit la valeur de la tension d'alimentation de la source de lumière 12. Le module de pilotage électronique 13 comporte au moins une carte support 15 de composants électroniques, sensiblement plane, à partir de laquelle se déploient un faisceau de câbles électriques 14 (visibles sur les figures 3 et 5). Dans le cas illustré, la carte 15 est recouverte d'un couvercle 16, servant notamment de moyen de protection aux composants électroniques.

La carte 15 comprend des composants électroniques non illustrés situés sur une première face 17 de la carte, sur laquelle est rigidement fixé le couvercle 16. Le couvercle 16 présente une portion centrale 16a bombée recouvrant les composants électroniques de la carte et délimitée par une paroi latérale périphérique 16b, ainsi qu'un contour 18 sensiblement plan plaqué contre la carte prolongeant cette paroi latérale périphérique.

Pour la mise en position du couvercle 16 sur la première face 17 de la carte 15, on peut prévoir des moyens d'indexage 19 par coopération de pions 19a portés par la carte 15 avec des orifices formés dans des doigts 19b portés par le couvercle. La fixation du couvercle sur la carte est ensuite réalisée par tous moyen, par exemple par collage.

Le module de pilotage électronique 13 présente, à un premier bord d'extrémité 20, une portion de connexion 21 configurée pour coopérer avec un support 30 tel qu'il va être décrit ci-après, et à un deuxième bord d'extrémité opposé 22, une portion de guidage 23 configurée pour coopérer avec une tranchée aménagée dans une paroi interne au boîtier telle qu'elle sera décrite ci-après.

La portion de connexion 21 comprend au moins une nervure 24 rectiligne, s'étendant perpendiculairement, ou sensiblement perpendiculairement, au plan défini par la carte 15 support des composants électroniques. Dans l'exemple illustré, la nervure 24 s'étend sur toute la largeur du module de pilotage 13, c'est-à-dire sur toute la dimension du premier bord d'extrémité 20, d'un coin à un autre de la carte 15.

Il est notable, dans l'exemple illustré sur les 3 et 6, que la portion de connexion est formée par une nervure rectiligne 24 prolongeant sensiblement perpendiculairement le contour 18 du couvercle 16. Le couvercle peut notamment être réalisé en acier galvanisé (et par exemple un acier galvanisé du type DX 54 + Z 100). Le matériau choisi permet de réaliser la nervure par pliure depuis un bord du couvercle 16, en étant suffisamment rigide pour tenir lorsqu'on extrait le support. Notamment, la nervure rectiligne 24 peut prolonger un bord du couvercle par une pliure, de sorte que la portion de connexion 21 présente une forme en L, avec le contour 18 du couvercle et la nervure rectiligne 24. Cette nervure a pour effet d'accrocher le couvercle et par conséquent l'ensemble du module de pilotage électronique 13 au support 30. On comprendra que la nervure rectiligne pourrait être agencée à distance constante du premier bord du module de pilotage électronique, la forme profilée de la portion de connexion étant alors différente de la forme en L précédemment décrite et illustrée à titre d'exemple sur les figures. Dans chacun de ces cas, on pourra noter que la nervure rectiligne 24 s'étend à distance de la face latérale périphérique 16b du couvercle 16, séparée par une portion de dégagement 25 plane formée par le contour 18.

Tel que cela est notamment visible sur les figures 3 et 6, la carte 15 support des composants électroniques présente une première tranche 26, perpendiculaire aux premier 20 et deuxième 22 bords d'extrémité du module de pilotage électronique 13, qui s'étend axialement au-delà du premier bord et au-delà du deuxième bord en formant des éléments en saillie 27, 28 du module de pilotage, parmi lesquels un premier élément en saillie 27 agencé au voisinage du premier bord d'extrémité 20 et de la nervure rectiligne 24, et un deuxième élément en saillie 28 agencé au voisinage du deuxième bord d'extrémité opposé 22.

Tel que cela a été précisé, le module de pilotage électronique est configuré pour coopérer avec un logement 29 aménagé dans un support 30, illustré seul à la figure 4. Ce support 30 comprend une surface plane de forme rectangulaire aux coins arrondis et formant un capot 31, et une glissière 32 formée de deux parois prolongeant perpendiculairement une face interne 33 du capot, de manière à être parallèles en regard l'une de l'autre et définir entre elles le logement 29 pour recevoir le module de pilotage électronique 13.

La glissière 32 comprend une rainure 34, agencée sur la face interne de l'une des deux parois, en étant sensiblement perpendiculaire à la direction générale du passage défini entre les deux parois de la glissière. La rainure 34 s'étend sensiblement sur toute la longueur du support 30, et elle débouche sur au moins un premier côté 35 de ce support, de sorte que la nervure rectiligne 24 du module de pilotage électronique puisse être insérée dans le logement 29 par coulissement dans la rainure 34 depuis ce premier côté du support. Dans le mode de réalisation illustré, la rainure ne débouche que sur un côté du support et le fond de la rainure dans le support définit une butée à l'insertion du module 13 dans le support selon une direction d'insertion sensiblement parallèle à la direction d'allongement de la rainure.

Lorsque le module 13 est insérée dans le support, la position du module est maintenue par l'utilisation d'une vis de serrage 36 vissée dans un alésage 36a (visible sur la figure 6) s'étendant parallèlement à la direction d'insertion du module dans le support, la tête de vis formant alors une butée pour au moins le premier élément en saillie 27 empêchant l'extraction du module hors du support.

Dans la position assemblée du module 13 dans le support 30, illustrée notamment sur la figure 6, on peut noter que la nervure rectiligne 24 est disposée dans la rainure 34 définissant au moins en partie le logement 29. La rainure 34 comporte une première paroi, ici une paroi supérieure, 34a et une deuxième paroi, ici une paroi inférieure, 34b reliées par une paroi de fond 34c de la rainure. L'épaisseur de la nervure rectiligne 24 est dimensionnée pour que celle-ci soit en regard des première et deuxième parois 34a, 34b.

Ainsi, le module 13 ne peut être séparé du support 30 lorsqu'on exerce une force F (visible sur les figures 6 et 10) suivant une direction perpendiculaire à celle de la nervure 24 du module et de la rainure 34 du support. Lors de l'extraction, la nervure 24 vient se plaquer contre l'une ou l'autre des parois 34a, 34b et ce contact entraîne la nervure et le module avec le mouvement du support.

On comprend que tout type de logement apte à accueillir et à maintenir en position la nervure 24 du module est susceptible de convenir, à partir du moment où une sollicitation par une force F telle que précitée ne permet pas de séparer le support 30 du module 13.

Selon l'invention, la présence de cette nervure rectiligne dans la rainure du support permet la manipulation simultanée du support et du module de pilotage électronique. Ceci est notamment avantageux lorsque l'on souhaite réaliser une extraction d'un module défectueux hors du boîtier d'un dispositif lumineux, tel que cela va être décrit par la suite.

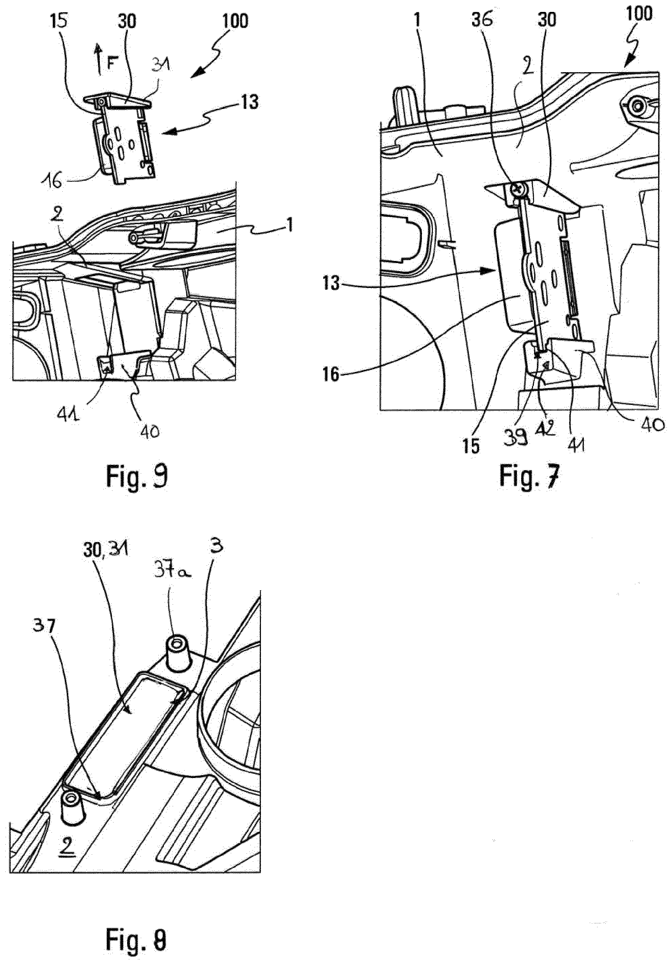

Tel qu'illustré sur la figure 2, et de façon plus visible sur la figure 7, le support 30 est à l'origine une partie intégrante du boîtier 1, dans le sens où le support est venu de matière avec une paroi 2 du boîtier. Dans le cas illustré, la paroi 2 dans laquelle est intégrée le support 30 est la paroi supérieure du boîtier, et la force F qui est exercée pour extraire le support et le module associé hors du boîtier est alors essentiellement verticale, mais on comprendra que d'autres orientations pourraient être prévues sans sortir du contexte de l'invention, dès lors que l'agencement de la nervure du module et de la rainure du support est sensiblement perpendiculaire à la direction de cette force F.

En se référant à la figure 6 notamment, on comprend que le capot 31 du support 30 est formé par la paroi 2 du boîtier 1, et que la glissière 32 s'étend en saillie de cette paroi 2 vers l'intérieur du boîtier. Le capot 31 est délimité dans la paroi 2 par une zone de prédécoupe 3 distincte du reste de la paroi 2. Notamment, on pourra prévoir que cette zone de prédécoupe 3 est une zone de fragilité formée par une épaisseur de la paroi plus faible en cette zone qu'en le reste de la paroi 2.

Dans l'exemple illustré, la paroi 2 présente autour de cette zone de prédécoupe 3 un bossage 37 formant saillie de la face externe de la paroi 2 du boîtier. A l'intérieur de ce bossage, la paroi présente une épaisseur moindre que dans les autres zones, formant ainsi le capot 31. Tel qu'illustré, la zone de fragilité peut être accentuée par des encoches 38 réalisées de façon continue sur tout le pourtour du capot ou ponctuellement, de sorte que l'on facilite ainsi la prédécoupe du capot 31. Il sera compris que des encoches pourraient également être réalisées sur la face interne de la paroi du boîtier.

Le bossage périphérique 37 est réalisé sur la paroi de sorte que la projection sur la paroi 2 de chacun des éléments du module de pilotage 13 et du support 30 se trouve à l'intérieur de ce bossage. La zone de prédécoupe est de la sorte au droit du module de pilotage électronique. Ainsi, on s'assure, tel que cela sera décrit après, que lorsque la paroi est découpée au niveau de ce bossage périphérique, l'ensemble formé par le module et le support peut être extrait du boîtier par l'ouverture formée par la découpe de la paroi au niveau du bossage périphérique.

Tel que cela est visible sur la figure 1 ou sur la figure 8, deux fûts de vissage 37b sont aménagés de part et d'autre du bossage périphérique.

Dans le mode de réalisation illustré, le module de pilotage électronique 13 est disposé dans le boîtier entre le logement 29 formé dans le support 30, solidaire d'une des parois 2 délimitant le pourtour extérieur du boîtier, et un logement additionnel 39 formé dans une paroi interne 40 munie d'une tranchée 41.

La tranchée 41 s'étend parallèlement à la rainure 34 réalisée dans le support 30. Elle débouche sur au moins le premier côté 42 de la paroi interne et elle est ouverte en direction du support 30, de sorte que les ouvertures de la tranchée 41 et de la glissière 32 sont en regard l'une de l'autre en l'absence du module. En d'autres termes, la tranchée est définie par deux parois parallèle et une paroi de fond qui s'étend sensiblement parallèlement à la rainure 34. La tranchée est dimensionnée pour que la portion de guidage 23, agencée au deuxième bord d'extrémité 22 du module de pilotage, puisse y être logée, au moins au niveau du deuxième élément en saillie 28.

Lorsque le support 30 est formé dans la paroi 2 supérieure du boîtier et que la paroi interne 40 s'étend verticalement sous ce support, le module de pilotage électronique repose contre la paroi de fond de la tranchée et la nervure rectiligne est dans la position illustrée sur la figure 6, c'est-à-dire à distance de l'une et l'autre des parois de la rainure 34 du support 30.

La figure 7 illustre l'ensemble installé dans le boîtier 1 en position nominale, c'est-à-dire en position de fonctionnement. Au lieu d'y placer une extrémité de la carte 15, on pourrait également situer dans la tranchée 41 une extrémité du couvercle 16. On comprend que le rôle de la tranchée 41 est ici de faciliter la mise en position du module de pilotage 13, aussi bien lors du montage initial que lors des remplacements des modules de pilotage défectueux, tout en permettant de retirer à l'opposé de cette tranchée un module défectueux, par extraction du support 30 et avec lui du module 13. Par ailleurs, il convient de noter que la paroi interne 40 et la tranchée dans laquelle est logée le module permettent de bloquer en rotation le module et de limiter les vibrations de celui-ci.

Le boitier 1 du dispositif d'éclairage et/ou de signalisation est ici un boîtier plastique, injecté en une seule étape, avec une zone de fixation du module de pilotage électronique comportant le support et sa rainure, et la paroi interne en regard l'une de l'autre.

Avant la première utilisation du boîtier, on insère une carte support de composants électroniques et le couvercle associé dans la glissière 32 du support 30, et le cas échéant dans la tranchée 41. Les éléments en saillie de la carte pénètrent dans le logement 29 et le logement additionnel 39 par le premier côté 35 du support et par le premier côté 42 de la paroi interne. Simultanément, la nervure rectiligne 24 s'insère dans la rainure 34 du support. L'opérateur pousse le module de pilotage pour le faire coulisser à l'intérieur de la glissière 32 et de la paroi interne 40 jusqu'à ce que la nervure rectiligne entre en contact avec le fond de la rainure 34.

Dans cette position, le dernier mouvement possible, à savoir la translation en sens inverse du sens d'insertion, est bloqué par le vissage de la vis de serrage 36 dans l'alésage 36a. Ainsi, le module de pilotage 13 est rigidement attaché au support 30, dans une position nominale.

L'opérateur peut alors assembler dans le boîtier le reste des composants, et notamment les composants optiques, du dispositif lumineux.

On va maintenant décrire un procédé de démontage dont le but est d'extraire le module de pilotage, a fortiori la carte de pilotage 15, du boîtier 1, pour procéder au remplacement d'un module de pilotage défectueux.

Lorsque l'on souhaite changer la carte de pilotage, ou la réparer, on découpe la paroi 2 du boîtier porteuse du support 30, au niveau du bossage périphérique 37, et ce depuis l'extérieur du boîtier. Le fait d'avoir prévu une prédécoupe au niveau de ce bossage périphérique, c'est-à-dire une zone de fragilité et par exemple de moindre épaisseur, permet à l'opérateur de découper la zone adéquate avec un outillage simple, par exemple un simple couteau à lame rétractable ou « Cutter », sans perdre de précision et d'efficacité.

L'opérateur tire alors sur la portion de paroi découpée, correspondant au capot 31 de du support 30, et il entraîne avec le capot l'intégralité du support et le module de pilotage rendu solidaire de cette translation par l'emprisonnement de la nervure rectiligne du module dans la rainure du support. Avant de retirer complètement du boîtier l'ensemble formé par le support et le module, via l'ouverture dans la paroi ainsi découpée, l'opérateur déconnecte les câbles 14 du module défectueux.

Lorsque l'opérateur soulève le support 30, la nervure 24 maintenant le module 13 dans le support 30 permet l'entraînement du module 13 avec le support. On retrouve alors l'agencement illustré à la figure 9 dans lequel le module et le support sont extraits du boîtier.

On comprend à ce stade l'intérêt d'avoir une nervure rectiligne formée sur le module et configurée pour coopérer avec la rainure du support, à savoir la possibilité de retirer facilement le module du boîtier, par l'extérieur, sans nécessité de réaliser des vissages et des dévissages à l'intérieur du boîtier. L'extraction du module défectueux est rapide, simple, et n'engendre pas de risques de dommages pour le dispositif. L'extraction du module est d'autant plus simple et rapide qu'une prédécoupe est réalisée sur une paroi du boîtier. La prédécoupe peut par exemple prendre la forme de lignes de fragilité réalisées volontairement au niveau des contours du boîtier, ou encore de découpes discontinues.

Une fois le module défectueux retiré, l'opérateur dispose un nouveau module de pilotage dans le boîtier en l'insérant par le passage préalablement formé dans la paroi 2, c'est-à-dire par l'ouverture formé à l'intérieur du bossage périphérique. Il convient de noter que ce nouveau module de pilotage présente avantageusement un ensemble, formé d'une carte, de composants électroniques neufs et d'un couvercle, similaire à celui qui a été précédemment extrait du boîtier, alors que le support diffère du support précédemment retiré, en ce que le capot est plus grand. De la sorte, lorsque le nouveau module de pilotage électronique est déposé, le capot 31 vient reposer contre le bossage périphérique. On peut prévoir un joint d'étanchéité entre le capot et le bossage périphérique pour assurer l'étanchéité du boîtier. Par ailleurs, le nouveau capot comporte des alésages permettant le passage de vis de fixation, ici non représentées, dimensionnées pour coopérer avec les fûts de vissage 37b afin de bloquer en position le nouveau module de pilotage électronique.

On comprend dès lors que le positionnement du nouveau module de pilotage électronique peut s'effectuer aussi bien par butée du capot sur le bossage périphérique, que par butée du capot sur les fûts de vissage, ou par butée du deuxième élément en saillie 28 du nouveau module de pilotage électronique dans la tranchée de la paroi interne.

La mise en place du nouveau module a ainsi été réalisée avec des opérations de vissage faites à l'extérieur du boîtier, de sorte que l'on évite les risques de chute de vis ou de détérioration de l'intérieur du produit via un tournevis par exemple. Seule une opération de raccordement électrique est nécessaire à l'intérieur du boîtier, c'est-à-dire une opération sans outillage.

Telle qu'elle vient d'être décrite, l'invention permet de simplement remplacer un module de pilotage électronique défectueux sans avoir à risquer la détérioration de composants optiques et/ou électroniques présents par ailleurs dans le boîtier du dispositif lumineux dans lequel est appliquée l'invention.

## Revendications

1. Module de pilotage électronique (13) d'une source de lumière comportant au moins une carte (15) support de composants électroniques configurée pour être reçue par un premier de ses bords dans une position nominale dans un logement (29) d'un support (30) solidaire d'une paroi (2) d'un boitier (1) d'un dispositif lumineux (100), **caractérisé en ce que** le module de pilotage électronique présente au voisinage de ce premier bord une portion de connexion (21) comportant au moins une nervure (24) s'étendant perpendiculairement, ou sensiblement perpendiculairement, au plan défini par la carte.

2. Module de pilotage électronique selon la revendication 1, **caractérisé en ce que** la portion de connexion (21) est profilée.

3. Module de pilotage électronique selon l'une des revendications 1 ou 2, **caractérisé en ce que** la nervure (24) prolonge le premier bord.

4. Module de pilotage électronique selon la revendication précédente, **caractérisé en ce que** la portion de connexion (21) présente une forme en L.

5. Module de pilotage électronique selon l'une des revendications 1 ou 2, **caractérisé en ce que** la nervure (24) s'étend à distance constante du premier bord.

6. Module de pilotage électronique selon l'une des revendications précédentes, **caractérisé en ce que** la nervure (24) s'étend sur tout le long du premier bord.

7. Module de pilotage électronique selon l'une des revendications précédentes, **caractérisé en ce qu'**il comporte un couvercle (16) de protection des composants électroniques supportés par la carte (15), et **en ce que** la nervure (24) de la portion de connexion (21) est formée sur le couvercle (16).

8. Module de pilotage électronique selon la revendication précédente, **caractérisé en ce que** le couvercle (16) présente une portion centrale bombée (16a) recouvrant les composants électroniques de la carte (15) et un contour (18) sensiblement plan plaqué contre la carte, la nervure (24) de la portion de connexion (21) étant réalisée sur ce contour de manière à former un dégagement (25) entre la portion centrale et la portion de connexion.

9. Dispositif lumineux (100), comprenant au moins une source de lumière (12) logée dans un boîtier (1) ainsi qu'au moins un module de pilotage électronique (13) selon l'une des revendications précédentes destiné à piloter au moins cette source de lumière.

10. Dispositif lumineux selon la revendication précédente, **caractérisé en ce que** le module de pilotage électronique (13) est reçu dans un logement (29) formée dans un support (30) solidaire d'une paroi (2) du boitier (1).

11. Dispositif lumineux selon la revendication précédente, **caractérisé en ce que** le support (30) est venu de matière avec la paroi (2) du boîtier (1).

12. Dispositif lumineux selon la revendication 10 ou 11, **caractérisé en ce que** la paroi (2) du boîtier (1) comporte une prédécoupe (3) au droit du module de pilotage électronique (13).

13. Dispositif lumineux selon la revendication précédente, **caractérisé en ce que** la prédécoupe (3) comporte au moins une zone de la paroi (2) du boîtier (1) de moindre épaisseur.

14. Dispositif lumineux selon l'une des revendications 9 à 13, **caractérisé en ce que** le logement (29) est formé dans un support (30) comportant un capot (31), formé par une partie de la paroi du boîtier, et une glissière (32) prolongeant le capot vers l'intérieur du boîtier, ladite glissière présentant une forme complémentaire de celle de la portion de connexion (21) du module de pilotage électronique.

15. Dispositif lumineux selon la revendication précédente, **caractérisé en ce que** la glissière (32) comporte une rainure (34) configurée pour recevoir la nervure (24) en saillie perpendiculaire de la portion de connexion (21) du module de pilotage électronique.

16. Dispositif lumineux selon la revendication précédente, **caractérisé en ce que** la rainure (34) s'étend selon une direction parallèle au plan défini par le capot (31).

17. Dispositif lumineux selon l'une des revendications 9 à 16, comprenant une vis de serrage (36) du module de pilotage électronique (13) dans le support (30).

18. Dispositif lumineux selon l'une quelconque des revendications 9 à 17, **caractérisé en ce que** le boîtier (1) comporte une paroi interne (40) comprenant une tranchée (41) de maintien du module de pilotage électronique (13) au niveau d'un deuxième de ses bords (22), opposé au premier bord (20).

19. Dispositif lumineux selon la revendication précédente, en combinaison avec au moins la revendication 15, **caractérisé en ce que** la tranchée (41) s'étend parallèlement ou sensiblement parallèlement à la rainure (34) agencée dans la glissière (32).

20. Procédé de remplacement d'un module de pilotage électronique (13) agencé à l'intérieur d'un dispositif lumineux (100) en étant raccordé électriquement à une ou plusieurs sources de lumière (12), le module de pilotage électronique (13) étant logé dans une position nominale dans un support (30) solidaire d'une paroi (2) d'un boîtier (1) du dispositif lumineux (100), avec au moins une nervure (24) du module de pilotage électronique s'étendant dans une rainure (34) du support (30) sensiblement parallèlement à ladite paroi (2), le procédé comprenant une étape de déconnexion électrique de la ou des sources de lumière avec le module de pilotage électronique à remplacer, une étape de découpe partielle de la paroi du boîtier autour du logement, depuis l'extérieur du boîtier, une étape d'extraction du support (30) par rapport au dispositif lumineux (100), le support emportant le module de pilotage électronique (13) par coopération de la nervure (24) du module de pilotage électronique et de la rainure (34) du support, une étape de positionnement d'un nouveau module de pilotage électronique équipé d'un support comprenant un capot de fermeture s'adaptant à l'ouverture, une étape de raccordement électrique et une étape de fixation d'un capot (31) de fermeture du nouveau module de pilotage électronique sur la paroi (2) du boîtier (1) depuis l'extérieur du boîtier.

## Patentansprüche

1. Elektronisches Steuermodul (13) einer Lichtquelle, umfassend mindestens eine Trägerkarte (15) für elektronische Komponenten, welche dafür ausgelegt ist, um durch einen ersten ihrer Ränder in einer Nominalposition in einer Aufnahme (29) einer Halterung (30) aufgenommen zu werden, welche fest mit einer Wand (2) eines Gehäuses (1) einer Leuchtvorrichtung (100) verbunden ist, **dadurch gekennzeichnet, dass** das elektronische Steuermodul in der Nähe dieses ersten Randes einen Verbindungsabschnitt (21) aufweist, welcher mindestens eine Rippe (24) umfasst, welche sich senkrecht oder im Wesentlichen senkrecht zu der durch die Karte definierten Ebene erstreckt.

2. Elektronisches Steuermodul nach Anspruch 1, **dadurch gekennzeichnet, dass** der Anschlussabschnitt (21) profiliert ist.

3. Elektronisches Steuermodul nach einem der Ansprüche 1 oder 2, **dadurch gekennzeichnet, dass** die Rippe (24) den ersten Rand verlängert.

4. Elektronisches Steuermodul nach dem vorhergehenden Anspruch, **dadurch gekennzeichnet, dass** der Anschlussabschnitt (21) eine Form eines L aufweist.

5. Elektronisches Steuermodul nach einem der Ansprüche 1 oder 2, **dadurch gekennzeichnet, dass** sich die Rippe (24) in konstantem Abstand von dem ersten Rand erstreckt.

6. Elektronisches Steuermodul nach einem der vorhergehenden Ansprüche, **dadurch gekennzeichnet, dass** sich die Rippe (24) entlang des gesamten ersten Randes erstreckt.

7. Elektronisches Steuermodul nach einem der vorhergehenden Ansprüche, **dadurch gekennzeichnet, dass** es einen Deckel (16) zum Schutz der von der Karte getragenen elektronischen Bauteile (15) umfasst, und dass die Rippe (24) des Verbindungsabschnitts (21) an dem Deckel (16) ausgebildet ist.

8. Elektronisches Steuermodul nach dem vorhergehenden Anspruch, **dadurch gekennzeichnet, dass** der Deckel (16) einen gewölbten, zentralen Abschnitt (16a), welcher die elektronischen Komponenten der Karte (15) abdeckt, und eine im Wesentlichen ebene Kontur (18) aufweist, welche gegen die Karte gepresst ist, wobei die Rippe (24) des Verbindungsabschnitts (21) an dieser Kontur derartig ausgeführt ist, um zwischen dem zentralen Abschnitt und dem Verbindungsabschnitt einen Gang (25) auszubilden.

9. Leuchtvorrichtung (100), umfassend mindestens eine Lichtquelle (12), welche in einem Gehäuse (1) untergebracht ist, sowie mindestens ein elektronisches Steuermodul (13) nach einem der vorhergehenden Ansprüche, welches dafür vorgesehen ist, um zumindest diese Lichtquelle zu steuern.

10. Leuchtvorrichtung nach dem vorhergehenden Anspruch, **dadurch gekennzeichnet, dass** das elektronische Steuermodul (13) in einer Aufnahme (29) aufgenommen ist, welche in einer Halterung (30) ausgebildet ist, welche fest mit einer Wand (2) des Gehäuses (1) verbunden ist.

11. Leuchtvorrichtung nach dem vorhergehenden Anspruch, **dadurch gekennzeichnet, dass** die Halterung (30) einstückig mit der Wand (2) des Gehäuses (1) ausgebildet ist.

12. Leuchtvorrichtung nach Anspruch 10 oder 11, **dadurch gekennzeichnet, dass** die Wand (2) des Gehäuses (1) eine Vorstanzung (3) in der Verlängerung zu dem elektronischen Steuermodul (13) umfasst.

13. Leuchtvorrichtung nach dem vorhergehenden Anspruch, **dadurch gekennzeichnet, dass** die Vorstanzung (3) mindestens einen Bereich der Wand (2) des Gehäuses (1) mit geringerer Dicke umfasst.

14. Leuchtvorrichtung nach einem der Ansprüche 9 bis 13, **dadurch gekennzeichnet, dass** die Aufnahme (29) in einer Halterung (30) ausgebildet ist, welche eine Abdeckung (31), welche durch einen Teil der Wand des Gehäuses gebildet wird, und eine Gleitführung (32) umfasst, welche die Abdeckung in Richtung des Inneren des Gehäuses verlängert, wobei die Gleitführung eine komplementäre Form zu derjenigen des Verbindungsabschnitts (21) des elektronischen Steuermoduls aufweist.

15. Leuchtvorrichtung nach dem vorhergehenden Anspruch, **dadurch gekennzeichnet, dass** die Gleitführung (32) eine Nut (34) umfasst, welche dafür ausgelegt ist, um die senkrecht aus dem Verbindungsabschnitt (21) des elektronischen Steuermoduls vorspringende Rippe (24) aufzunehmen.

16. Leuchtvorrichtung nach dem vorhergehenden Anspruch, **dadurch gekennzeichnet, dass** sich die Nut (34) gemäß einer Richtung parallel zu der durch die Abdeckung (31) definierten Ebene erstreckt.

17. Leuchtvorrichtung nach einem der Ansprüche 9 bis 16, umfassend eine Schraube zum Festziehen (36) des elektronischen Steuermoduls (13) in der Halterung (30).

18. Leuchtvorrichtung nach einem der Ansprüche 9 bis 17, **dadurch gekennzeichnet, dass** das Gehäuse (1) eine innere Wand (40) umfasst, welche eine Schneise (41) zum Halten des elektronischen Steuermoduls (13) im Bereich eines zweiten (22) seiner Ränder aufweist, welcher dem ersten Rand (20) gegenüberliegt.

19. Leuchtvorrichtung nach dem vorhergehenden Anspruch in Kombination mit zumindest Anspruch 15, **dadurch gekennzeichnet, dass** sich die Schneise (41) parallel oder im Wesentlichen parallel zu der Nut (34) erstreckt, welche in der Gleitführung (32) eingerichtet ist.

20. Verfahren zum Auswechseln eines elektronischen Steuermoduls (13), welches im Inneren einer Leuchtvorrichtung (100) eingerichtet ist, indem es mit einer oder mehreren Lichtquellen (12) elektrisch verbunden ist, wobei das elektronische Steuermodul (13) in einer Nominalposition in einer Halterung (30), welche fest mit einer Wand (2) eines Gehäuses (1) der Leuchtvorrichtung (100) verbunden ist, mit mindestens einer Rippe (24) des elektronischen Steuermoduls untergebracht ist, welche sich in einer Nut (34) der Halterung (30) im Wesentlichen parallel zu der Wand (2) erstreckt, wobei das Verfahren umfasst einen Schritt des elektrischen Trennens der einen oder mehreren Lichtquellen von dem auszuwechselndem elektronischen Steuermodul, einen Schritt des Teilschnitts der Wand des Gehäuses um die Aufnahme herum von einem Außenbereich des Gehäuses, einen Schritt der Extraktion der Halterung (30) in Bezug auf die Leuchtvorrichtung (100), wobei die Halterung durch Zusammenwirkung der Rippe (24) des elektronischen Steuermoduls mit der Nut (34) der Halterung das elektronische Steuermodul (13) mitnimmt, einen Schritt des Positionierens eines neuen elektronischen Steuermoduls, welches mit einer Halterung ausgerüstet ist, welche eine Schließabdeckung umfasst, welche sich an die Öffnung anpasst, einen Schritt des elektrischen Verbindens und einen Schritt des Befestigens einer Abdeckung (31) zum Schließen des neuen elektronischen Steuermoduls an der Wand (2) des Gehäuses (1) von dem Außenbereich des Gehäuses aus.

## Claims

1. Electronic control module (13) for controlling a light source comprising at least one board (15) for supporting electronic components that is configured to be received by a first of its edges in a nominal position in a compartment (29) of a holder (30) that is rigidly connected to a wall (2) of a housing (1) of a lighting device (100), **characterized in that** the electronic control module has, in the vicinity of this first edge, a connection portion (21) comprising at least one rib (24) extending perpendicularly, or substantially perpendicularly, to the plane defined by the board.

2. Electronic control module according to Claim 1, **characterized in that** the connection portion (21) is profiled.

3. Electronic control module according to one of Claims 1 and 2, **characterized in that** the rib (24) continues the first edge.

4. Electronic control module according to the preceding claim, **characterized in that** the connection portion (21) is L-shaped.

5. Electronic control module according to one of Claims 1 and 2, **characterized in that** the rib (24) extends at a constant distance from the first edge.

6. Electronic control module according to one of the preceding claims, **characterized in that** the rib (24) extends along the entire length of the first edge.

7. Electronic control module according to one of the preceding claims, **characterized in that** it comprises a cover (16) for protecting the electronic components supported by the board (15), and **in that** the rib (24) of the connection portion (21) is formed on the cover (16).

8. Electronic control module according to the preceding claim, **characterized in that** the cover (16) has a domed central portion (16a) covering the electronic components of the board (15) and a substantially planar contour (18) flat against the board, the rib (24) of the connection portion (21) being produced on this contour so as to form a clearance (25) between the central portion and the connection portion.

9. Lighting device (100), comprising at least one light source (12) housed in a housing (1) and at least one electronic control module (13) according to one of the preceding claims intended to control at least this light source.

10. Lighting device according to the preceding claim, **characterized in that** the electronic control module (13) is received in a compartment (29) formed in a holder (30) that is rigidly connected to a wall (2) of the housing (1).

11. Lighting device according to the preceding claim, **characterized in that** the holder (30) is integral with the wall (2) of the housing (1).

12. Lighting device according to Claim 10 or 11, **characterized in that** the wall (2) of the housing (1) has a precut (3) in line with the electronic control module (13).

13. Lighting device according to the preceding claim, **characterized in that** the precut (3) comprises at least one region of the wall (2) of the housing (1) of lower thickness.

14. Lighting device according to one of Claims 9 to 13, **characterized in that** the compartment (29) is formed in a holder (30) comprising a cap (31), formed by a part of the wall of the housing, and a guide (32) continuing the cap in the direction of the interior of the compartment, a shape of said guide being complementary to that of the connection portion (21) of the electronic control module.

15. Lighting device according to the preceding claim, **characterized in that** the guide (32) includes a groove (34) configured to receive the rib (24) projecting perpendicularly from the connection portion (21) of the electronic control module.

16. Lighting device according to the preceding claim, **characterized in that** the groove (34) extends in a direction parallel to the plane defined by the cap (31) .

17. Lighting device according to one of Claims 9 to 16, comprising a clamping screw (36) for clamping the electronic control module (13) in the holder (30).

18. Lighting device according to any one of Claims 9 to 17, **characterized in that** the housing (1) comprises an internal wall (40) comprising a trench (41) for holding the electronic control module (13) by a second of its edges (22), opposite the first edge (20) .

19. Lighting device according to the preceding claim, in combination with at least Claim 15, **characterized in that** the trench (41) extends parallel or substantially parallel to the groove (34) arranged in the guide (32).

20. Method for replacing an electronic control module (13) arranged inside a lighting device (100) and being electrically connected to one or more light sources (12), the electronic control module (13) being accommodated in a nominal position in a holder (30) that is rigidly connected to a wall (2) of a housing (1) of the lighting device (100), with at least one rib (24) of the electronic control module extending in a groove (34) of the holder (30) that is substantially parallel to said wall (2), the method comprising a step of electrically disconnecting the one or more light sources from the electronic control module to be replaced, a step of partially cutting the wall of the housing around the compartment, from the exterior of the housing, a step of removing the holder (30) with respect to the lighting device (100), the holder carrying the electronic control module (13) with it through cooperation of the rib (24) of the electronic control module and the groove (34) of the holder, a step of positioning a new electronic control module equipped with a holder comprising a closing cap suitable for the opening, an electrical connection step and a step of securing a closing cap (31) for the new electronic control module to the wall (2) of the housing (1) from the exterior of the housing.
